# EUROPEAN PATENT APPLICATION

(11) **EP 2 961 055 A1**
(43) Date of publication of application: **30.12.2015**
(21) Application number: 13875406.4
(22) Date of filing: 22.11.2013
(51) Int. Cl.: H02M 7/48, H02K 11/00

(54) **MOTOR WITH INVERTER**

(30) Priority: 20.02.2013 JP 2013031369
(71) Applicant: Nissan Motor Company, Limited, Kanagawa-ku Yokohama-shi Kanagawa 221-0023 (JP)
(72) Inventor: NAKAYAMA, Hiroyuki, Atsugi-shi Kanagawa 243-0123 (JP)
(74) Representative: Hoefer & Partner Patentanwälte mbB
(86) International application number: PCT/JP2013/081508
(87) International publication number: WO 2014/129037

(57) **Abstract**

An inverter-integrated motor (1) including a motor housing (41) in which a rotor (23) and a stator (22) are accommodated and an inverter housing (42) in which a power module (31) of an inverter (3) with heat dissipating functions, with one end of the motor housing and one end of the inverter housing integrally joined. The power module is arranged inside the inverter housing on the other end thereof, and a heat diffusion member (44) is disposed between the power module and an inner surface of the inverter housing.

## Description

### TECHNICAL FIELD

The present invention relates to a motor with an integrated inverter or an inverter-integrated motor.

### BACKGROUND

Conventionally, it is known in a heat extraction structure of an inverter-integrated AC motor that a motor and a power module both representing heating elements are disposed to oppose each other and a cooling block of hollow cylinder is placed therebetween for forced cooling by a metal member of disk shape for element cooling (Patent Document 1).

### PRIOR ART LITERATURE

### PATENT DOCUMENT

Patent Document 1: JP 2007-116840 A

### SUMMARY OF THE INVENTION

### PROBLEM TO BE SOLVED BY THE INVENTION

However, in the conventional motor with inverter, since it is configured to cool the motor and the inverter representing heating elements by the cooling block provided therebetween, when the heat value of the electric motor and the inverter is large, a problem arises that cooling is not sufficient only through the cooling block.

The problem the present invention intends to solve is to provide an inverter-integrated motor with excellent heat radiation property.

### MECHANISM FOR SOLVING THE PROBLEM

The present invention solves the above problem by providing a power module via a heat diffusion or dissipation member on the end of an inverter housing having a heat radiation function.

### EFFECT OF THE INVENTION

In accordance with the present invention, since heat from the power module representing the main heating element of the inverter is diffused by the heat diffusion member and transmitted to the inverter housing, there is an effect of improving the heat diffusion due to increase in the heat diffusion area.

### BRIEF DESCRIPTION OF THE DRAWINGS

FIG. 1 is a sectional view of in the axial direction of an inverter-integrated motor according to an embodiment of the present invention;
FIG. 2 is an arrow view taken along the line II-II of FIG. 1;
FIG. 3 is a sectional view showing a manufacturing process of the inverter housing shown in FIG. 1;
FIG. 4 is a sectional view showing the manufacturing process of the inverter housing in another embodiment according to the present invention;
FIG. 5 is a sectional view in the axial direction showing an inverter-integrated motor in still another embodiment according to the present invention;
FIG. 6 is an arrow view taken along the line VI-VI of FIG. 5;
FIG. 7 is a perspective view illustrating one of the heat diffusion members with the power module of FIG.5; and
FIG. 8 is a sectional view showing the manufacturing process of the inverter housing shown in FIG. 5.

### EMBODIMENTS OF THE INVENTION

Now, a description is given of an embodiment according to the present invention with reference to accompanying drawings.

### "FIRST EMBODIMENT"

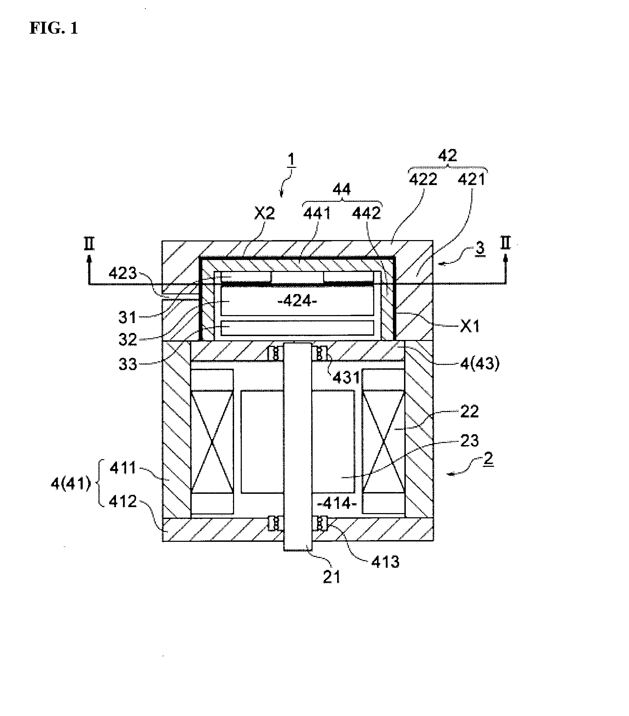

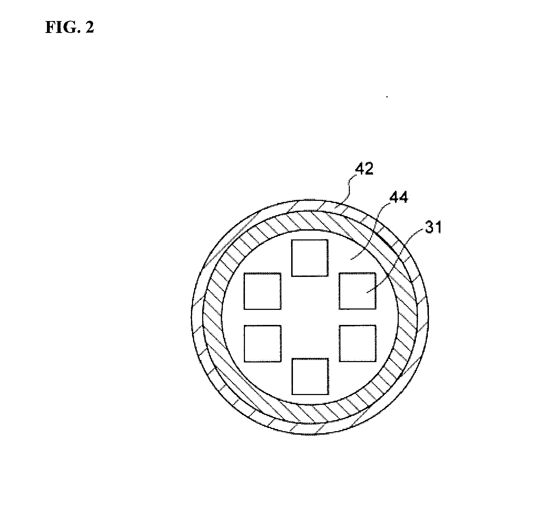

FIGS. 1, 2 show an inverter-integrated motor in a first embodiment of the present invention. The inverter-integrated motor 1 of the present embodiment is an electro-mechanical integrated device that integrates a motor 2 and the inverter 3. A rotary shaft 21, a stator 22, and a rotor 23 each being components of the motor 2 as well as a power module 31, a DC bus bar & smoothing capacitor 32 (indicated by reference numeral 32 for the DC bus bar and the smoothing capacitor collectively) and a circuit board 33 each representing components of the inverter 3 are accommodated in a housing 4. Note that the inverter-integrated motor 1 in the present embodiment is intended to include an inverter-integrated motor-generator having a power generation function by regeneration, as well.

The housing 4 of the present embodiment includes a motor housing 41, an inverter housing 42 and a partition bracket 43. The motor housing 41, the partition bracket 43 and the inverter housing 42 are juxtaposed in the axial direction in the mentioned order and joined together at associated flanges by a fastening means such as screws or bolts (not shown). Thus, joining of the motor housing 41 and the inverter housing 42 separate from the motor housing 41, each constituting part of accommodating housing 4, is also referred to as integration. Further, constructing the motor housing 41 and the inverter housing 42 in a single housing member is also referred to as integration.

The motor housing 41 has a cylindrical body 411 with open end surfaces in the axial direction and a bracket 412 that closes one end of the cylindrical body 411 for passing through the rotary shaft 21 for rotatable support. The cylindrical body 411 and the bracket 412 are fixed together by fastening means (not shown) such as welding, caulking, bolts and the like. The cylindrical body 411 and bracket 412 can be formed of a material of aluminum or the like having excellent heat diffusion. Also, a plurality of radiating fins may be formed on the outer surface of the cylindrical body 411 so that the heat transmitted to the motor housing 41 from the power module 31 may be radiated to the outside.

The inverter housing 42 is integrally molded into a bottomed cylindrical shape so as to have a cylindrical main body 421 and a bracket portion 422 for closing one end of the cylindrical main body 421. The inverter housing 42 can be formed of a material of aluminum or the like having excellent heat diffusion. Further, a plurality of heat dissipating fins may be provided on the outer surface of the bracket 422 so that the heat from the power module 31 transmitted to the inverter housing 42 may be dissipated to the outside. Note that the cylindrical main body 421 and the bracket portion 422 may be structured separately and fixed together by fastening means such as through welding, caulking, bolts, and the like. The other configurations of the inverter housing 42 will be described below.

The partition bracket 43 is interposed between the cylindrical body 411 of the motor housing 41 and the cylindrical main body 421 of the inverter housing 42 to serve as a bracket common to both the other bracket of the motor housing 41 and the other bracket of the inverter housing 42 so that dust in the motor housing 41 is prevented from entering into the inverter housing 42. In other words, the motor housing 41 and the inverter housing 42 are integrated in a position of this partition bracket 43. Note that the partition bracket 43 may be configured as part of the cylindrical body 411 of the motor housing 41, or, alternatively, part of the cylindrical main body 421 of the inverter housing 42.

A motor chamber 414 is formed in the motor housing 41, and an inverter chamber 424 is formed inside the inverter housing 42. In the center of the axial direction of these motor chamber 414 and the inverter chamber 424, the rotary shaft 21 is supported rotatably in both direction by bearings 413, 431. Further, the lower end of the rotary shaft 21 extends from the motor housing 41 to the outside, where the load is connected. As the load connected to the motor 2 in the present embodiment, a driving shaft of an electric vehicle or the like may be exemplified so that the motor is driven to output to the driving shaft, or the motor may be operative in a regenerative mode by receiving rotation of the driving shaft of the electric vehicle.

In the motor chamber 414, the stator 22 is fixed to the inner peripheral surface of the cylindrical body 411, and the rotor 23 is fixed to the rotary shaft 21 to be opposed to the inside of the stator with a gap.

The stator 22 is a stationary member that generates a rotating magnetic field, and includes a stator core for constituting a magnetic circuit, a stator coil wound on the stator core to generate the rotating magnetic field in response to AC power supplied from the inverter 3. The stator core, for example, is composed of a cylindrical magnetic body composed of a plurality of silicon steel sheets formed by stacking in the axial direction. The stator core is press-fitted to the inner peripheral surface of the cylindrical body 411 and fixed thereto with the outer peripheral surface of the stator core being fitted. The stator coil is formed with phase coils of three-phase (u-phase, v phase, w phase) by the coil conductor wound around the stator core being electrically connected. The three-phase coils are configured to be star-connected (i.e. Y-connected). In star connection, one end of each phase coil is electrical connected to form a neutral point. Note that the number of phases of the motor is not limited to three phases.

Although not shown, a lead conductor is electrically connected to the end of each phase coil of the stator coil (the end opposite to the neutral point side). Each lead conductor is a flat elongated conductor which also serves as the input terminal of the motor 2 and is derived in the axial end portion of the partition bracket 43 of the stator 22, specifically led in the axial direction from the side of the partition bracket 43 of the coil end of the stator coil and stretched from the motor chamber 414 to reach the inverter chamber 424 through a through-hole in the partition bracket 43, and is electrically connected to the corresponding phase terminal of the inverter 3.

Thus, the terminals of the inverter 3 and the phase coils of the stator coil of the motor 2 are electrically connected in the same phase. When the inverter-integrated motor 1 functions as a motor, the AC driving power of each phase output from the terminal of the inverter 3 is introduced to the corresponding phase coil of the stator coil via the lead conductor of the corresponding phase. In addition, when the inverter-integrated motor 1 functions as a generator, the AC regenerative power of each phase output from the stator coil is guided to a terminal of corresponding phase of the inverter 3.

The rotor 23 is a component that rotates by magnetic action of the stator 22, and is structured by a plurality of permanent magnets embedded inside a cylindrical magnetic material formed by stacking a plurality of silicon steel plates in the direction of the rotary shaft 21, or is constituted by arranging a plurality of permanent magnets on the outer peripheral surface of the magnetic body. In this case, permanent magnets of different polarity are alternately arranged at equal intervals in the circumferential direction.

Besides the permanent magnet described above, as the rotor 23, the so-called tandem Lundell type rotor structure may be used, which is provided with a rotor core for forming a magnetic circuit, a rotor coil wound in the rotor core for receiving the field current supplied from the outside such as vehicle battery via a brush and slip ring, and generating a magnetic flux in order to magnetize the claw-shaped magnetic poles, and permanent magnets disposed between the claw-shaped magnetic poles of different polarity of the rotor core.

Now, a description is made of the arrangement in the inverter chamber 424. In the inverter chamber 424, the heat diffusion member 44 is disposed in contact with the inner surface of the bracket portion 422 and the inner surface of the cylindrical main body 421 of the inverter housing 42. A power module 31 is mounted on the heat diffusion member 44, further a bus bar & smoothing capacitor 32 and the circuit board 33 are respectively fixed in this order.

It is preferable to form the heat diffusion member 44 from a high thermal conductively material of low cost, for example, metal material such as copper (398W / m · K) or aluminum (236W / m · K). The heat diffusion member 44 of the present embodiment is formed into a cup shape having a bottom surface 441 in contact with the bracket portion 422 of the inverter housing 42 and a side surface 442 in contact with the inner surface of the cylindrical main body 421. Between the inner surface of the bracket portion 422 and the bottom surface 441, adhesive or grease of small thermal resistance (these being indicated with X2) is interposed. The inner surface of the cylindrical main body 421 and the side surface 442 are joined and fixed together by a technique such as shrink fitting or press-fitting (these being indicated with X1).

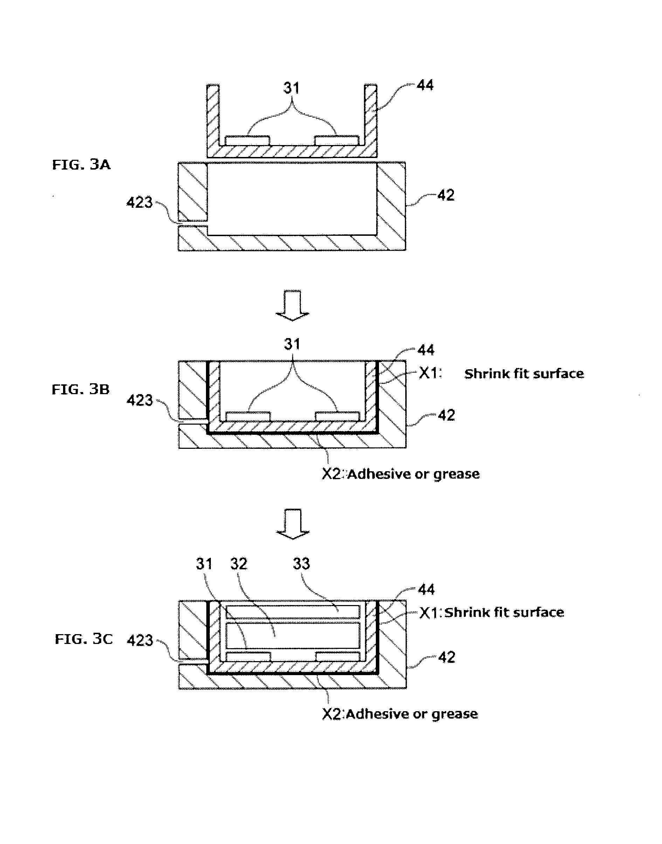

FIG. 3 shows an example of an assembling process in which, after a heat diffusion member 44 mounted with a power module 31 is jointly fixed to the inverter housing 42 by shrink fitting, a bus bar & smoothing condenser 32 and a circuit board 22 are attached. First, as shown in FIG. 3A, after the power module 31 has been mounted to the heat diffusion member 44, adhesive or grease is applied to the outer surface of the bottom surface of the heat diffusion member 44 and/or the inner surface of the bracket portion 422 of the inverter housing 42. Subsequently, as shown in FIG. 3B, the inverter housing 42 and the heat diffusion member 44 are fitted together in a state of being heated to a predetermined temperature below the heat resistant upper limit temperature of the power module 31.

When the inverter housing 42 is formed of aluminum material, and the heat diffusion member 44 formed of a copper material, since the thermal expansion coefficient of the aluminum material is 23.9 × 10 -6 /° C whereas the thermal expansion coefficient of copper material is 17.7 × 10 -6 /° C, if heated to the same temperature, the inner diameter of the inverter housing 42 expands more to facilitate fitting of both components, and, when cooled to room temperature, the inverter housing 42 and the heat diffusion member 44 are firmly fixed by shrink fitting. At this time, when one or more air vent holes 423 are formed in the cylindrical main body 421 of the inverter housing 42, the air between the inverter housing 42 and the heat diffusion member 44 is discharged during the fitting so that fitting may be done easily. In view of the air vent property, it is desirable to form the air vent hole 423 in the cylindrical main body 421 which is close to the bracket portion 422 side of the inverter housing 42.

Subsequently, as shown in FIG. 3C, the bus bar & smoothing capacitor 32 and the a sub-assembly is completed in which the heat diffusion member 44, the power module 31, the bus bar & smoothing capacitor 32, and the circuit board 33 are mounted on the inverter housing 42.

### "SECOND EMBODIMENT"

The manufacturing process according to the first embodiment shown in FIG. 3 is preferable when the thermal expansion coefficient of the molding material of the inverter housing 42 is larger than the thermal expansion coefficient of the molding material of the heat diffusion member 44. However, in a case in which the thermal expansion coefficients of both components are generally equal, or the thermal expansion coefficient of the molding material of the inverter housing 42 is smaller than that of the heat diffusion member 44, in place of shrink fitting, a press-fitting process may be employed. Note that this press-fitting process can be applied regardless of the magnitude of the thermal expansion coefficients of the molding material of the inverter housing 42 and of the thermal diffusion member 44.

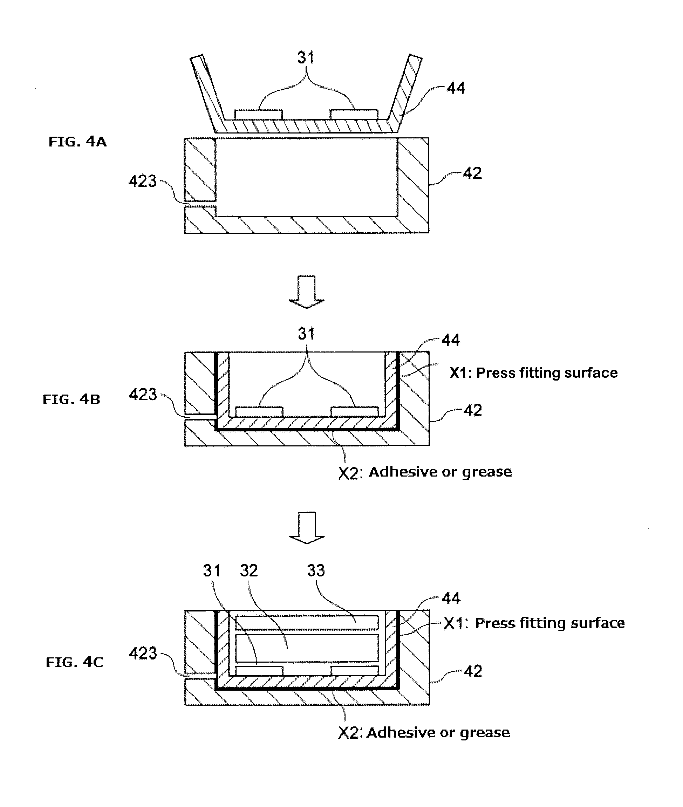

FIG. 4 shows an example of an assembling process in which, after a heat diffusion member 44 mounted with a power module 31 is jointly fixed to the inverter housing 42 by press-fitting, a bus bar & smoothing condenser 32 and a circuit board 22 are attached. First, as shown in FIG. 4A, after the power module 31 has been mounted to the heat diffusion member 44, adhesive or grease is applied to the outer surface of the bottom surface of the heat diffusion member 44 and/or the inner surface of the bracket portion 422 of the inverter housing 42. As shown in FIG. 4A, the heat diffusion member 44 is previously formed such that the side surface 442 is radially enlarged outward as it goes to the open end from the bottom surface 441. Then, as shown in FIG. 4B, the inverter housing 42 and the heat diffusion member 44 are press fitted.

At this time, when one or more air vent holes 423 are formed in the cylindrical main body 421 of the inverter housing 42, the air between the inverter housing 42 and the heat diffusion member 44 is discharged at the time of press-fitting to thereby facilitate press-fitting. In view of the air vent property, it is desirable to form the air vent hole 423 in the cylindrical main body 421 which is close to the bracket portion 422 side of the inverter housing 42.

Subsequently, as shown in FIG. 4C, the bus bar & smoothing capacitor 32 and the circuit board 33 are mounted to the power module 31. By this method, a sub-assembly is completed in which the heat diffusion member 44, the power module 31, the bus bar & smoothing capacitor 32, and the circuit board 33 are mounted on the inverter housing 42.

### "THIRD EMBODIMENT"

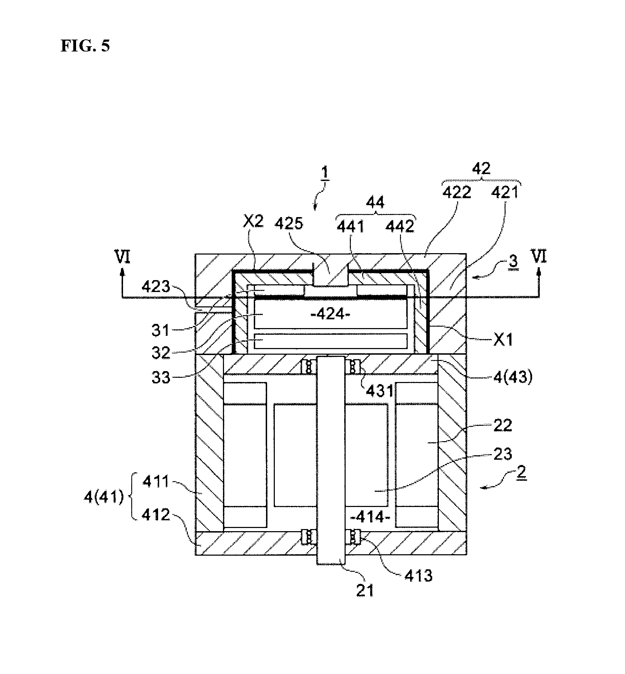

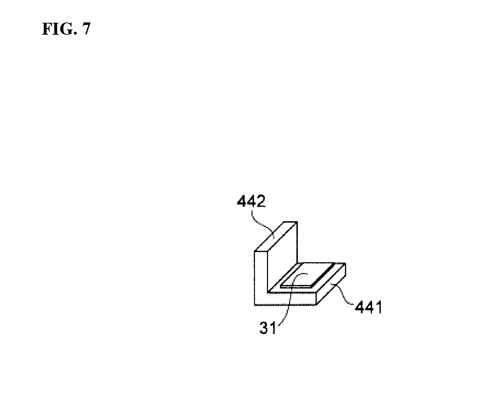

In the first and second embodiments described above, as the heat diffusion member 44, such a cup shaped member is used, which has a bottom surface 441 of circular flat shape and a side surface 442 upstanding from the circular flat bottom surface 441. However, since it is sufficient for the heat diffusion member 44 to be disposed between the power module 31 representing heat generating body and the inverter housing 41 to function to diffuse the heat generated in the power module 31. Thus, continuous arrangement in the circumferential direction is not required. FIGS. 5 to 7 show diagrams illustrating an inverter-integrated motor 1 in a third embodiment according to the present invention. For the same components as in the first and second embodiments, the same reference numerals are attached, and the descriptions are herein incorporated.

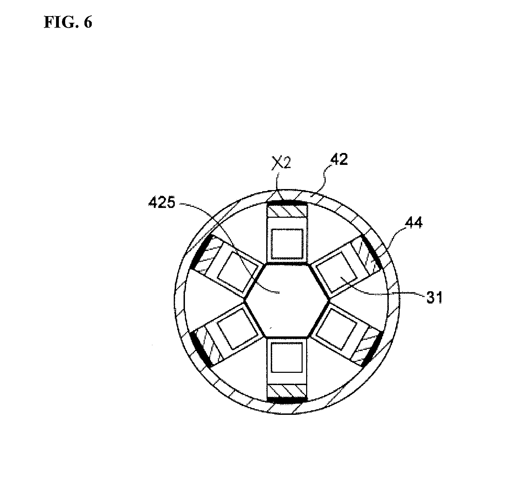

In the inverter-integrated motor of the present embodiment, the configuration of the heat diffusion member 44 as well as a joining and fixing structure of the heat diffusion member 44 to the inverter housing 42 are different from the inverter-integrated motor 1 of the first and second embodiments described above. That is, for each of the six power modules 31, as shown in FIG. 6, the heat diffusion member 44 is individually provided in this embodiment, which is formed in a deflected member with a bottom surface 441 and a side surface 442. Further, these six heat diffusion members 44 are arranged at equal intervals on the inner surface of the bracket portion 422 of the inverter housing 42. The width dimension of the bottom surface 441 and that of the side surface 442 of the heat dissipating member 44 may not be the same.

On the other hand, on the inner surface of the bracket portion 422 of the inverter housing 42,an engaging or locking projection 525 is formed, which is brought in contact with the six thermal diffusion members 44 at their respective front end of the bottom surface so that the front end of the bottom surface of each elastic heat diffusion member 44 abuts against the engaging projection 425, and the side surface is brought in contact with the inner surface of the cylindrical main body 421 of the inverter housing 42. Thus, the heat diffusion member 44 is fixedly joined to the inverter housing 42.

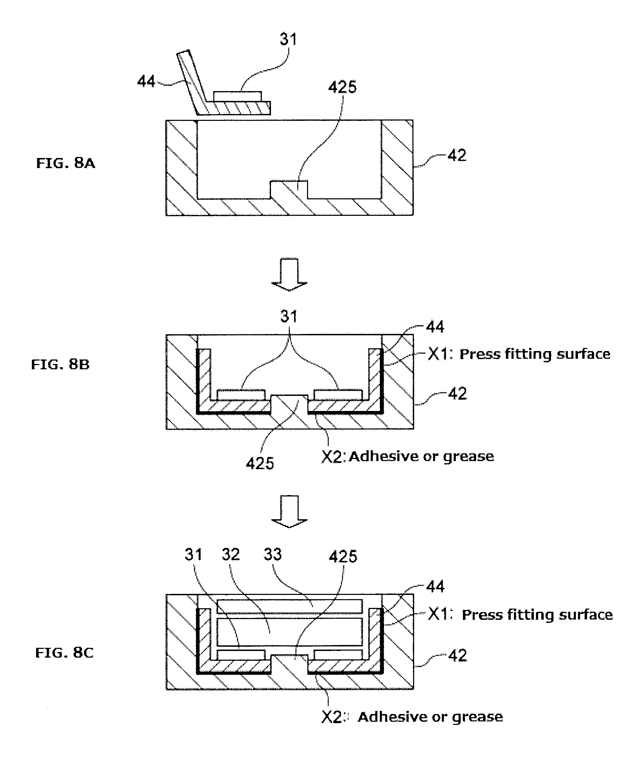

FIG. 8 shows an example of an assembling process in which, after six heat diffusion members 44 respectively mounted with a power module 31 are jointly fixed to the inverter housing 42 by press-fitting, a bus bar & smoothing condenser 32 and a circuit board 22 are attached. Each heat diffusion member 44 is previously formed such that the side surface 442 forms obtuse angle relative to the bottom surface 441.First, as shown in FIG. 8A, after installing a power module 31 to the heat diffusion member 44,then adhesive or grease is applied to the outer surface of the bottom surface of the heat diffusion member 44 and/or the inner surface of the bracket portion 422 of the inverter housing 42.

Then, as shown in FIG. 8B, the heat diffusion member 44 is press fitted in the inner surface of the inverter housing 42 such that the front end of the bottom surface 441 of the heat diffusion member 44 abuts against the engaging projection 425. At this time, since the air between the inverter housing 42 and the heat diffusion member 44 is discharged from the side during press-fitting, it is not necessary to form one or more air vent holes 423 as in the first or second embodiment described above.

Then, as shown in FIG. 8 C, the bus bar & smoothing capacitor 32 and the circuit board 33 are mounted to the power module 31. By the above process, a sub-assembly is completed in which the inverter housing 42, the heat diffusion member 44, the power module 31, the bus bar & smoothing condenser 32, and the circuit board and sub-assembly are assembled.

According to the inverter-integrated motor in the first to third embodiments constructed as described above, the following operational effects may be achieved.
(1) According to the inverter-integrated motor 1 of the present embodiment, since a heat diffusion member 44 of high thermal conductivity is provided between the bracket portion 422 and the cylindrical main body 421 of the inverter housing and the power module 31, the heat generated by the power module 31 is diffused by the heat diffusion member 44 and transmitted to the inverter housing in a state with an enlarged radiation area. As a result, because of the improvement in heat diffusion performance, the present invention may be applied to an air-cooled inverter-integrated motor, as well.
(2) Further, according to the inverter-integrated motor 1 in the present embodiment, since the adhesive or grease of small thermal resistance is interposed between the bottom surface 441 of the heat diffusion member 44 on which the power module 31 is mounted and the bracket portion 422 of the inverter housing 42, thermal stress can also be relaxed.
(3) Further, according to the inverter-integrated motor 1 of the present embodiment, since the power module 31 which generates high heat is disposed on side of the bracket portion 422 of the inverter housing 42, and the bus bar & smoothing condenser 32 and the circuit board of high thermal resistance are arranged on the side of the motor in this order, the heart generated by the power module 31 is blocked by the components 32, 33 of high thermal resistance in the inverter chamber 424 so that heat transfer to the motor chamber 414 and the heat transfer from the motor chamber 414 to the power module 31 may be suppressed.
(4) Further, according to the inverter-integrated motor 1 of the present embodiment, since the heat diffusion member 44 is joined and fixed to the inverter housing 42 by shrink fitting or press-fitting technique without using bolts, it is possible to suppress for the heat diffusion member 44 from being expanded in size.
(5) In particular, according to the inverter-integrated motor 1 in which the heat diffusion member 44 is jointly fixed by shrink fitting, although the joining portion of the power module 31 undergoes stress due to compressive stress at the heat diffusion member 44 in room temperature, when the power module 31 generates heat, the maximum value of the thermal stress acting on the joint portion of the power module 31 may be reduced due to heat expansion of the heat diffusion member 44.
(6) Further, according to the inverter-integrated motor 1 of the present embodiment, in which the heat diffusion member 44 is joined and fixed by press-fitting, irrespective of the thermal expansion coefficient of the materials constituting the heat diffusion member 44 and the inverter housing 42, joining may be achieved in an easy step with low thermal resistance. Also, the stress acting on the power module 31 may be reduced.
(7) Further, according to the inverter-integrated motor 1 of the present embodiment, in which the heat diffusion member 44 is joined and fixed by either shrink fitting or press-fitting, since an air vent hole 423 is formed in the cylindrical main body 421 of the inverter housing 42, it is possible to discharge the air between the heat diffusion member 44 and the inner surface of the inverter housing 42 to facilitate the shrink fitting or press-fitting operation smoothly.

The adhesive or grease X2 corresponds to a joining material according to the present invention.

### DESCRIPTION OF DRAWINGS

1 inverter-integrated motor
2 motor
   21 rotary shaft
   22 stator
   23 rotor
3 inverter
   31 power module
   32 DC bus bar & smoothing capacitor
   33 circuit board
4 housing
   41 motor housing
      411 cylindrical body
      412 bracket
      413 bearing
      414 motor chamber
   42 inverter housing
      421 cylindrical main body
      422 bracket portion
      423 air vent hole
      424 inverter chamber
      425 engaging or locking projection
   43 partition bracket 431 bearing
   44 thermal diffusion member
      441 bottom surface
      442 side surface

## Claims

1. An inverter-integrated motor including a motor housing in which a rotor and a stator are accommodated and an inverter housing having a heat dissipating function in which a power module is accommodated, one end of the motor housing and one end of the inverter housing integrally joined, wherein the power module is disposed inside the inverter housing on the other end of the inverter housing, and the inverter-integrated motor includes a heat diffusion member disposed between the power module and an inner surface of the inverter housing.

2. The inverter-integrated motor as claimed in claim 1, wherein the inverter includes the power module, a condenser, and bus bar & circuit board, wherein the power module, the condenser, and the bus bar & circuit board are disposed in this order from the other end of to the one end of the inverter housing.

3. The inverter-integrated motor as claimed in either claim 1 or 2, wherein the inverter housing includes a cylindrical main body and a flat shape bracket portion that closes the other end of the cylindrical main body, wherein the heat diffusion member is thermally joined to an inner surface of the cylindrical main body and an inner surface of the plate shape bracket portion.

4. The inverter-integrated motor as claimed in claim 3, wherein the heat diffusion member is joined to the inner surface of the flat shape bracket portion via a joining material and joined to the inner surface of the cylindrical main body of the inverter housing by shrink fitting.

5. The inverter-integrated motor as claimed in claim 3, wherein the heat diffusion member is joined to the inner surface of the flat shape bracket portion via a joining material and joined to the inner surface of the cylindrical main body of the inverter housing by press-fitting.

6. The inverter-integrated motor as claimed in either claim 4 or 5, wherein an air vent hole is formed in the cylindrical main body of the inverter housing.
